# EUROPEAN PATENT APPLICATION

(11) **EP 4 797 931 A1**
(43) Date of publication of application: **26.08.2026**
(21) Application number: 25221057.0
(22) Date of filing: 05.12.2025
(51) Int. Cl.: H10W 40/25, H10W 40/20, H10W 80/00, H10W 20/40, H10W 42/00

(54) **INTEGRATED CIRCUITS WITH THERMAL MANAGEMENT LAYER ADJACENT TO BOND LAYER FOR IMPROVED HEAT DISSIPATION**

(30) Priority: 19.02.2025 US 202519057145
(71) Applicant: Intel Corporation, Santa Clara, CA 95054 (US)
(72) Inventor: D'SILVA, Joseph, Hillsboro, 97124 (US); KOBRINSKY, Mauro J., Portland, 97229 (US); MANNEBACH, Ehren, Beaverton, 97007 (US); MILLS, Shaun, Hillsboro, 97124 (US); JIANG, Lei, Camas, 98607 (US); RAMAYYA, Edwin B., Beaverton, 97007 (US); LANDON, Colin D., Portland, 97229 (US); PANTUSO, Daniel, Portland, 97229 (US)
(74) Representative: 2SPL Patentanwälte PartG mbB

(57) **Abstract**

Techniques are provided herein to form semiconductor dies (or integrated circuits) with a thermally conductive layer adjacent to a bond interface to enhance the thermal dissipation from the semiconductor devices. A semiconductor die or integrated circuit includes any number of semiconductor devices within a device layer. A frontside interconnect region is provided above the device layer to, for example, route signals between the various semiconductor devices in the device layer. A thermally conductive layer may be provided above the frontside interconnect region, such as on a top-most layer of the frontside interconnect region. The thermally conductive layer includes a material having a thermal conductivity of, for example, at least 1.5 W/m·K. A bond layer may be provided adjacent (e.g., directly above or directly below) the thermally conductive layer and may be any suitable dielectric material, such as silicon dioxide.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, parasitic effects caused by heat can increasingly impact the device operation in an undesirable way. Accordingly, there remain a number of non-trivial challenges with respect to forming semiconductor devices.

### BRIEF DESCRIPTION OF THE DRAWINGS

Figure 1 is a cross-sectional view of die bonded to a package substrate with a heat sink.
Figure 2A - 2C are cross-sectional views of dies having a thermally conductive layer adjacent to a bond layer in various arrangements, in accordance with some embodiments of the present disclosure.
Figures 3A - 3D are cross-sectional views that illustrate various stages in an example process for fabricating a die having a carrier wafer bonded to a structure with a thermally conductive layer, in accordance with some embodiments of the present disclosure.
Figure 4 illustrates a computing system including one or more dies, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topography or otherwise be non-smooth, given real world limitations of the processing equipment and techniques used.

### DETAILED DESCRIPTION

Techniques are provided herein to form semiconductor dies with a thermally conductive layer adjacent to a bond interface to enhance the thermal dissipation from the semiconductor devices. The techniques can be used in any number of integrated circuit applications. A semiconductor die includes any number of semiconductor devices within a device layer. A frontside interconnect region is provided above the device layer to, for example, route signals between the various semiconductor devices in the device layer. A thermally conductive layer may be provided above the frontside interconnect region, such as on a top-most layer of the frontside interconnect region. According to some embodiments, the thermally conductive layer includes a metal such as titanium or copper, or generally any material having a thermal conductivity of at least 1.5 W/m·K, at least 15 W/m·K, at least 100 W/m·K, or at least 300 W/m·K. In some examples, the material layer includes a dielectric material with a high thermal conductivity, such as diamond, silicon carbide, aluminum nitride, or boron nitride. A bond layer may be provided adjacent (e.g., directly above or directly below) the thermally conductive layer and may be any suitable dielectric material, such as silicon dioxide. The presence of the thermally conductive layer provides greater heat dissipation up through the layer stack, such as from the semiconductor device layer and through the frontside interconnect region towards a heat sink arranged on top of the die, according to some embodiments. Terms such as integrated circuit, integrated circuit structure, IC, die, semiconductor die, and the like may all be used interchangeably herein. Numerous variations and embodiments will be apparent in light of this disclosure.

### General Overview

As previously noted above, there remain a number of non-trivial challenges with respect to integrated circuit fabrication. In more detail, as devices become smaller and more densely packed, heat dissipation from the devices increasingly becomes a challenge. Thermal conduction between the semiconductor devices within a device layer and a heat sink (e.g., a carrier wafer and/or metal structure on the carrier wafer) for a die with backside interconnects is limited by the thermal resistance of the bond layer that mechanically connects the frontside interconnect region of the die to the carrier wafer. This bond is often a fusion bond between a planarized silicon dioxide layer on the interconnect region and a thermally grown silicon dioxide layer on the carrier wafer. These bond materials are in the heat conduction path between the devices and the heat sink, and the heat conduction is especially limited in devices using backside contacts for power delivery due to the lack of a semiconductor substrate beneath the devices. The bond materials used in conventional device designs are poor thermal conductors and thus transistor cooling is not as efficient as, for example, technologies that are based on front-side power delivery.

Thus, techniques are provided herein to form a thermally conductive heat spreader layer adjacent to the bond layer interface between a carrier substrate and a remainder of the die having the semiconductor devices in order to reduce the effective thermal resistance in the heat path between the devices and the heat sink, according to some embodiments. The die includes multiple different layers, including a device layer having a plurality of semiconductor devices (e.g., transistors). Beneath the device layer, the substrate has been removed and replaced with a backside interconnect region having one or more backside interconnect layers. The one or more backside interconnect layers may be used to route power or signals to the underside of various transistor elements of the device layer, such as the underside of source or drain regions and/or the underside of gate structures, or to through-via structures for connecting to the topside of transistor elements. A frontside interconnect region may be provided above the device layer and includes any number of frontside interconnect layers. The frontside interconnect layers may be used to route signals between any of the semiconductor devices.

A bond interface (e.g., a bond layer) is between a top surface of the frontside interconnect region and a surface of a carrier wafer in order to bond the carrier wafer to the rest of the die. According to some embodiments, a thermally conductive layer is arranged either directly above or below the bond layer and may include a metal, such as any of titanium, ruthenium, or copper, or may include a thermally conductive dielectric material, such as any of aluminum nitride, boron nitride, silicon carbide, or diamond. The thermally conductive layer may have a thermal conductivity of, for example, at least 1.5 W/m·K, at least 5 W/m·K, at least 15 W/m·K, at least 100 W/m·K, at least 300 W/m·K, or generally higher than the thermal conductivity of silicon dioxide. According to some embodiments, the thermally conductive layer is deposited onto a non-planar top surface of the frontside interconnect region (e.g., having a roughness variation greater than 50 nm, or greater than 100 nm) and has a substantially planar top-side surface with roughness variation of less than 1 nm or less than 2 nm. In some examples, the thermally conductive layer has a greatest thickness between about 0.1 µm and about 5 µm.

According to an embodiment, a die includes a plurality of semiconductor devices, an interconnect region above the plurality of semiconductor devices and having a plurality of interconnect layers, a material layer over the interconnect region, a dielectric bond layer on the material layer, and a substrate on the dielectric bond layer. The material layer has a thermal conductivity of, for example, at least 1.5 W/m·K.

According to another embodiment, an electronic device includes a chip package having one or more dies (or integrated circuits or IC structures). At least one of the one or more dies includes a device layer comprising one or more semiconductor devices, one or more interconnect layers above the device layer, a material layer on a top surface of a topmost interconnect layer of the one or more interconnect layers, a dielectric bond layer on the material layer, and a substrate on the dielectric bond layer. The material layer has a thermal conductivity of, for example, at least 1.5 W/m·K.

According to another embodiment, an integrated circuit includes a plurality of semiconductor devices, an interconnect region above the plurality of semiconductor devices and having a plurality of interconnect layers, a dielectric bond layer over the interconnect region, a material layer on the dielectric bond layer, and a substrate on the material layer. The material layer has a thermal conductivity of, for example, at least 1.5 W/m·K.

The techniques can be used with any type of transistors, including both planar or non-planar transistors. Non-planar transistors include finFETs (sometimes called tri-gate transistors), nanowire and nanoribbon transistors (sometimes called gate-all-around transistors), or forksheet transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a high-thermal conductivity material (e.g., silicon carbide, diamond, aluminum nitride, or boron nitride) adjacent to (e.g., directly above or below) a dielectric bond interface between a carrier substrate and a remaining portion of the semiconductor die.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer. A layer may partially or completely fill a given recess or space or volume. A space or volume that is at least partially within a given layer and devoid of any solid fill materials may be referred to herein as an airgap or a void (used interchangeably herein). Such an airgap or void may be filled with one or more gasses (e.g., oxygen, nitrogen, air, to name a few examples), or be devoid of any gases.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

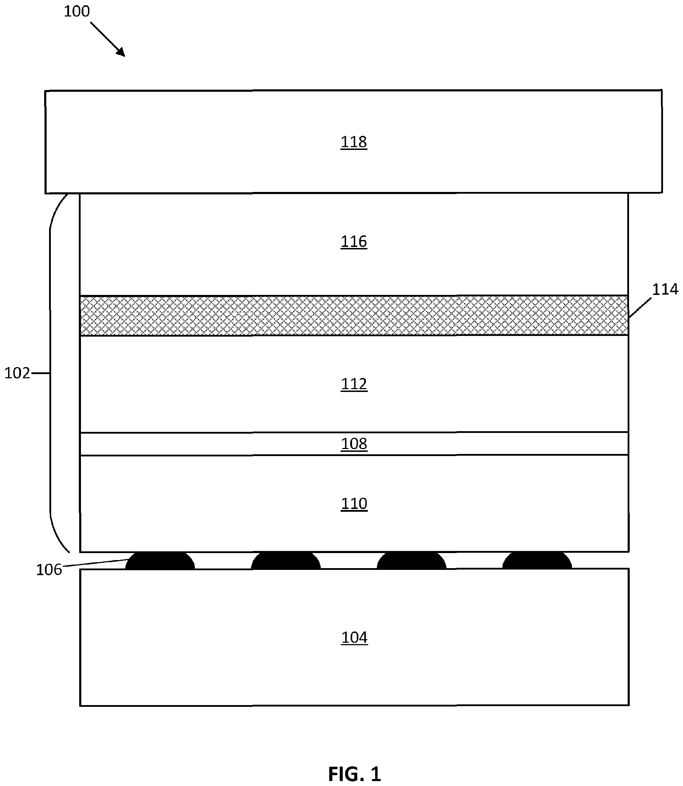

Figure 1 is a cross-sectional view taken across a chip package 100 having an example die 102. Die 102 is bonded to a package substrate 104 using connections 106, which may be implemented with any number of standard or proprietary connection mechanisms, such as solder bumps, ball grid array (BGA), pins, or wire bonds, to name a few examples. Package substrate 104 may be any standard or proprietary package substrate, but in some cases includes a dielectric material having conductive pathways (e.g., including conductive vias and lines) extending through the dielectric material between the faces of package substrate 104, or between different locations on each face. Package substrate 104 may have a thickness less than 1 millimeter (e.g., between 0.1 millimeters and 0.5 millimeters), although any number of package geometries can be used. In some examples, package substrate 104 is thicker, such as greater than 1.5 mm thick.

Die 102, which may also be referred to, for example, as a semiconductor die, or integrated circuit, or integrated circuit structure, includes a device layer 108 between a backside interconnect region 110 and a frontside interconnect region 112. Device layer 108 includes any number of semiconductor devices. The semiconductor devices may be planar devices, or non-planar metal oxide semiconductor (MOS) transistors, such as tri-gate (e.g., finFET) or gate-all-around (GAA) transistors. Other devices may be present as well within device layer 108, such as diodes, resistors, or capacitors. Backside interconnect region 110 may include any number of dielectric interconnect layers having any number of conductive vias and conductive lines to couple to the underside of elements from any of the semiconductor devices in device layer 108. In some examples, backside interconnect region 110 includes one or more conductive lines that act as power or ground rails. Frontside interconnect region 112 may include any number of dielectric interconnect layers having any number of conductive vias and conductive lines to couple to the top side of elements from any of the semiconductor devices in device layer 108. In some examples, frontside interconnect region 112 includes one or more conductive lines that carry signals between different devices in device layer 108.

A bond layer 114 is provided between the top of frontside interconnect region 112 and a carrier substrate 116. Carrier substrate 116 may be a semiconductor substrate, such as a silicon or silicon germanium substrate, although other substrate materials may be used as well. Carrier substrate 116 is significantly thicker compared to the combined thickness of backside interconnect region 110, device layer 108, and frontside interconnect region 112. For example, the combined thickness of backside interconnect region 110, device layer 108, and frontside interconnect region 112 may be on the order of a few micrometers, such as between 1 micrometer and 5 micrometers, while the thickness of carrier substrate 116 is on the order of tens of micrometers or hundreds of micrometers, such as between 50 micrometers and 800 micrometers. Bond layer 114 may also be on the order of a few micrometers thick, such as between 1 micrometer and 10 micrometers. A heat sink 118 may be arranged on a top surface of carrier substrate 116 to dissipate heat conducted through carrier substrate 116.

Bond layer 114 may be formed via a fusion bond between layers of dielectric material, such as between layers of silicon dioxide. While this leads to a strong bond with carrier substrate 116, the material is a poor thermal conductor. As a result, heat generated from the semiconductor devices in device layer 108 cannot dissipate as easily through the various layers above device layer 108 to reach heat sink 118. The additional heat retention limits how densely the devices can be arranged and also limits the devices' operating frequencies.

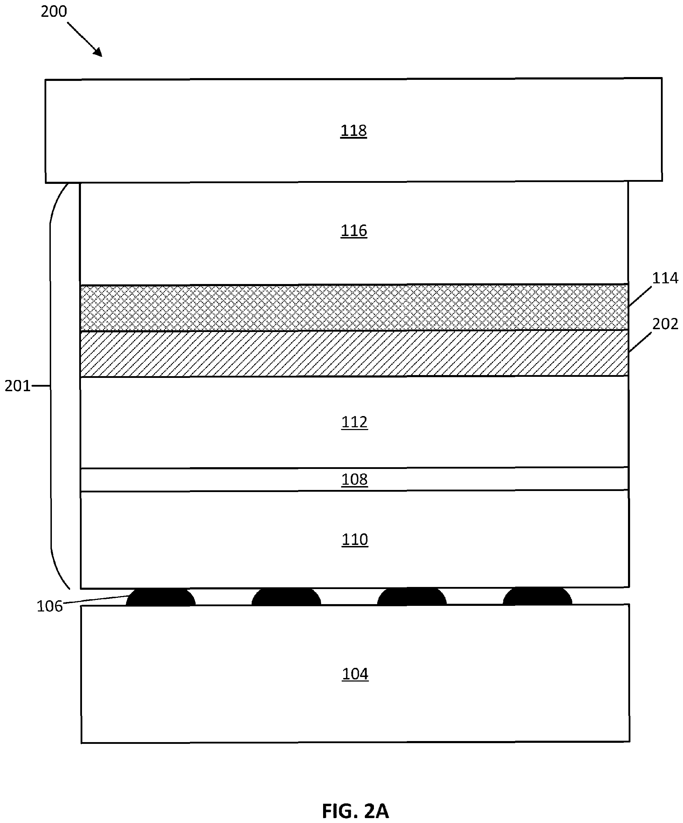

Figure 2A illustrates another cross-section of a chip package 200 having a die 201 with a material layer 202 having a relatively high thermal conductivity, according to some embodiments. Material layer 202 may include a conductive material, such as a metal. In some examples, material layer 202 includes titanium, ruthenium, or copper. In some examples, material layer 202 includes a non-metal material with a high thermal conductivity, such as aluminum nitride, aluminum oxide, boron nitride, silicon carbide, or diamond. Generally, material layer 202 may include any material having a thermal conductivity of, for example, at least 1.5 W/m·K, at least 15 W/m·K, at least 100 W/m·K, or at least 300 W/m·K. Material layer 202 is arranged between frontside interconnect region 112 and bond layer 114, according to some embodiments. For example, material layer 202 may be deposited directly on a topmost layer of frontside interconnect region 112, and bond layer 114 may be formed directly over material layer 202.

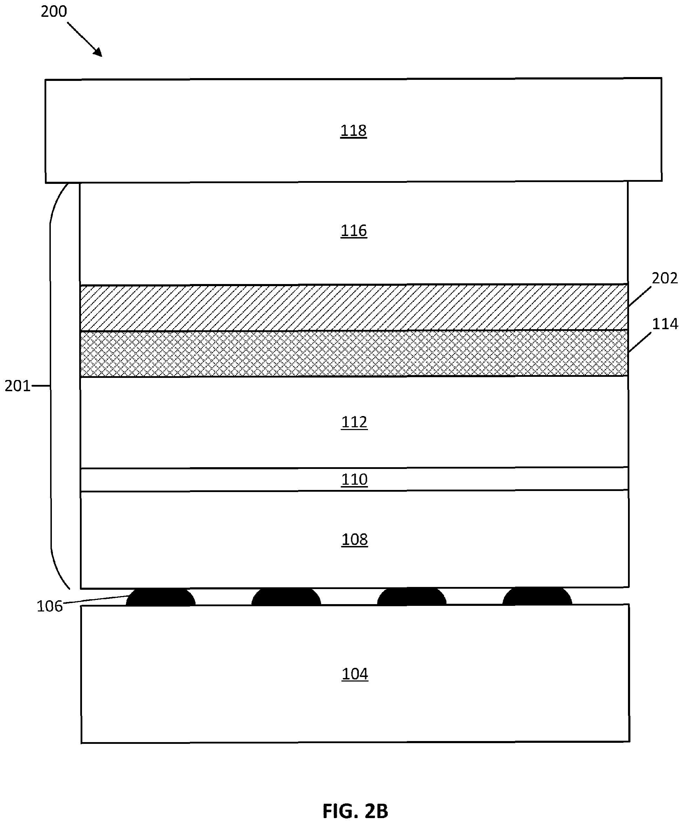

Figure 2B illustrates another cross-section of die 201 having material layer 202 between bond layer 114 and carrier substrate 116, according to some embodiments. At least a portion of bond layer 114 may be formed directly on a topmost layer of frontside interconnect region 112, and material layer 202 may be formed directly on carrier substrate 116 prior to any bonding procedure. The properties of each of the layers may be the same as discussed above with reference to Figure 2A.

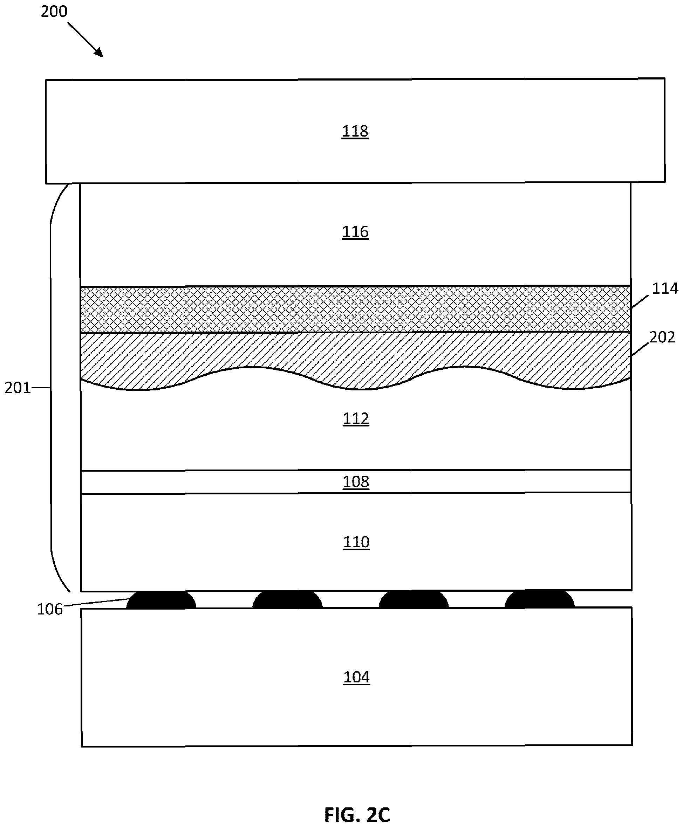

Figure 2C illustrates another cross-section of die 201 showing how material layer 202 can be used to fill in the roughness of the topmost layer of frontside interconnect region 112, according to some embodiments. The topmost layer of frontside interconnect region 112 may have a roughness variation on the order of hundreds of nanometers (e.g., between 100 nm and 500 nm). Accordingly, material layer 202 may be first deposited and subsequently polished to provide a planar top surface over the roughness variation of frontside interconnect region 112. In some examples, the top surface of material layer 202 is polished using chemical mechanical polishing (CMP) to achieve a roughness variation of less than 1 nm or less than 2 nm. At least a portion of bond layer 114 may then be deposited on the top surface of material layer 202. Material layer 202 may have a greatest thickness between about 0.1 micrometer and about 5 micrometers, or at least thick enough to adequately fill in the roughness variation of the topmost layer of frontside interconnect region 112.

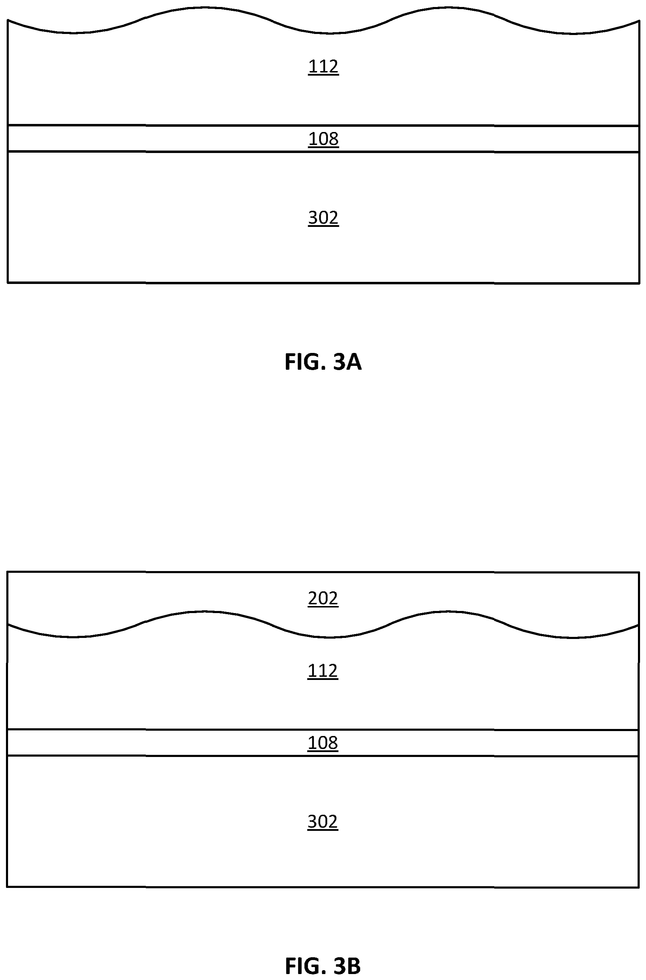

Figures 3A - 3D include cross-sectional views that collectively illustrate an example process for forming a die, according to some embodiments. The illustrated die structure may be part of a larger chip package, such as a system-on-chip package, that includes other dies and/or package elements not depicted. Example materials and process parameters are given, but other materials and process parameters may be used as well, as will be appreciated in light of this disclosure.

Figure 3A illustrates device layer 108 formed on a substrate 302 along with frontside interconnect region 112 formed over device layer 108, according to some embodiments. Substrate 302 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 302 can be a semiconductor-on-insulator substrate having device layer 108 over a buried insulator layer (e.g., silicon over silicon dioxide). Alternatively, substrate 302 can be a multilayer substrate or superlattice suitable for forming nanowires or nanoribbons (e.g., alternating layers of silicon and SiGe, or alternating layers indium gallium arsenide and indium phosphide). Any number of substrates can be used.

As noted above, frontside interconnect region 112 includes any number of interconnect layers stacked on one another. Each interconnect layer includes a dielectric material (e.g., silicon dioxide) and any number of conductive structures passing through the dielectric material to route signals to any of the devices in device layer 108. The top surface of the topmost layer of frontside interconnect region 112 may have a roughness variation of hundreds of nanometers, as depicted by the wavy topography.

Figure 3B illustrates the structure of Figure 3A following the formation of a thermally conductive material layer 202 on a top surface of frontside interconnect region 112, according to some embodiments. As noted above, material layer 202 may include a suitably high thermal conductivity material, such as any material with a thermal conductivity of at least 1.5 W/m·K, at least 15 W/m·K, at least 100 W/m·K, or at least 300 W/m·K. Example materials for material layer 202 include diamond, silicon carbide, aluminum nitride, aluminum oxide, or boron nitride. Material layer 202 may also include a metal material, such as copper. In some examples, the top surface of material layer 202 is polished using chemical mechanical polishing (CMP) to achieve a roughness variation of less than 1 nm or less than 2 nm. Material layer 202 may have a greatest thickness between about 0.5 micrometer and about 5 micrometers, or at least thick enough to adequately fill in the roughness variation of the topmost layer of frontside interconnect region 112. Material layer 202 may be deposited using any suitable deposition technique, such as chemical vapor deposition (CVD), physical vapor deposition (PVD), or by using a spin-on dielectric.

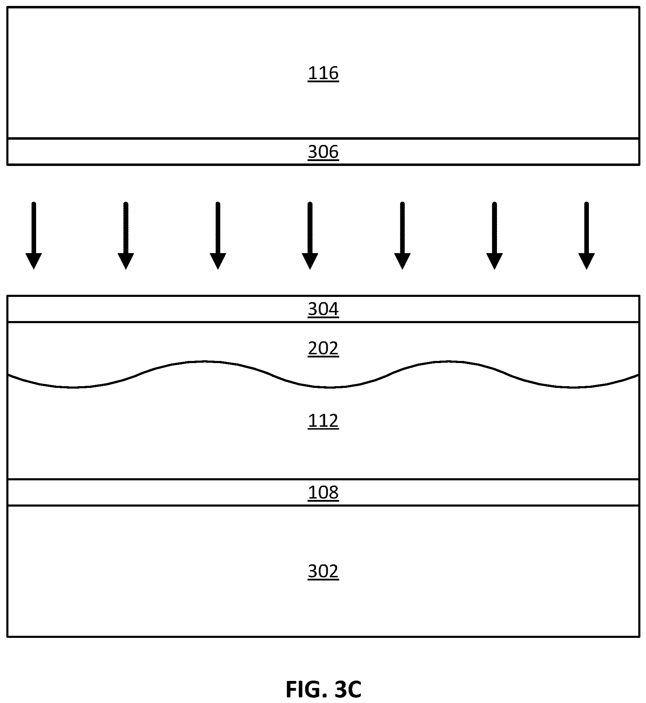

Figure 3C illustrates the structure of Figure 3B following the formation of a first bond interface layer 304 on material layer 202, according to some embodiments. First bond interface layer 304 may have the same material composition as bond layer 114 discussed above. Thus, according to some embodiments, first bond interface layer 304 includes a dielectric material, such as silicon dioxide. First bond interface layer 304 may be deposited using any suitable deposition technique, such as CVD, PVD, or by using a spin-on dielectric. For relatively thin layers, atomic layer deposition (ALD) may be used to form first bond interface layer 304.

According to some embodiments, a carrier substrate 116 having a second bond interface layer 306 is bonded to first bond interface layer 304, according to some embodiments. Second bond interface layer 306 may have substantially the same material composition as first bond interface layer 304. In some examples, each of first bond interface layer 304 and second bond interface layer 306 include silicon dioxide. A fusion bond may be used to seal the interface between first bond interface layer 304 and second bond interface layer 306. In some embodiments, second bond interface layer 306 is thermally grown on a semiconductor carrier substrate 116. In other examples, second bond interface layer 306 is formed using any of the same techniques described above for first bond interface layer 304.

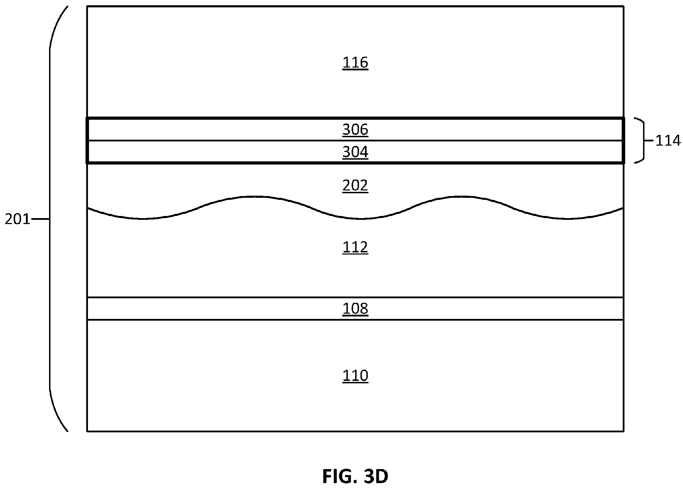

Figure 3D illustrates the structure of Figure 3C where the completed die 201 includes bond layer 114 composed of both first bond interface layer 304 and second bond interface layer 306, according to some embodiments. Material layer 202 having a thermal conductivity of, for example, at least 1.5 W/m·K is directly adjacent to bond layer 114. Once the bonding has been completed, substrate 302 is removed from beneath device layer 108 using any combination of polishing, grinding, or etching processes. Once substrate 302 has been removed, or at least the majority of substrate 302 has been removed, backside interconnect region 110 is formed in its place beneath device layer 108. As noted above, backside interconnect region 110 includes any number of interconnect layers stacked on one another. Each interconnect layer includes a dielectric material (e.g., silicon dioxide) and any number of conductive structures passing through the dielectric material. In some examples, the conductive structures within backside interconnect region 110 provide power and ground signals to the various devices in device layer 108.

### Example System

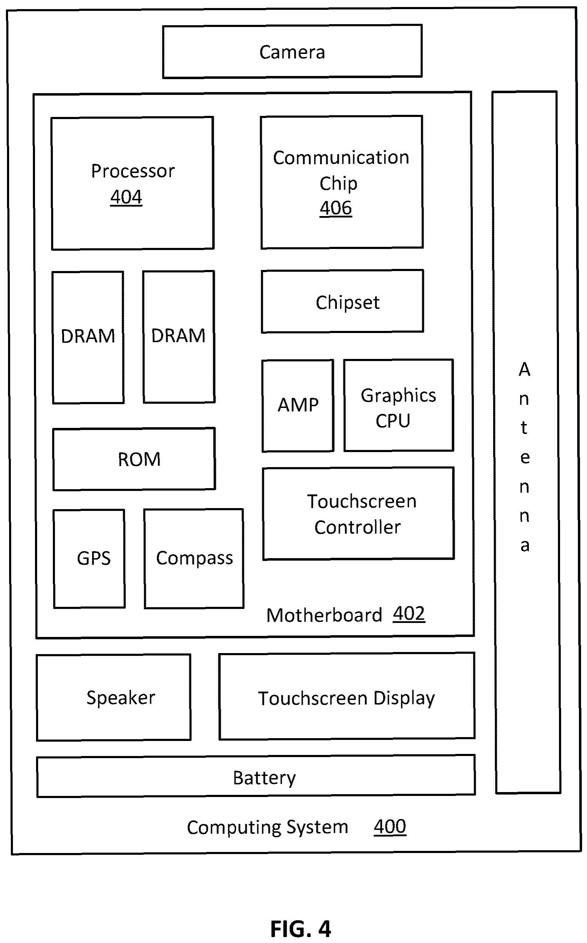

FIG. 4 is an example computing system implemented with one or more of the integrated circuit structures as disclosed herein, in accordance with some embodiments of the present disclosure. As can be seen, the computing system 400 houses a motherboard 402. The motherboard 402 may include a number of components, including, but not limited to, a processor 404 and at least one communication chip 406, each of which can be physically and electrically coupled to the motherboard 402, or otherwise integrated therein. As will be appreciated, the motherboard 402 may be, for example, any printed circuit board (PCB), whether a main board, a daughterboard mounted on a main board, or the only board of system 400, etc.

Depending on its applications, computing system 400 may include one or more other components that may or may not be physically and electrically coupled to the motherboard 402. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 400 may include one or more die structures configured in accordance with an example embodiment, such as a die having a bond interface with a carrier substrate where the bond interface is adjacent to a material layer with a high thermal conductivity. In some embodiments, multiple functions can be integrated into one or more chips (e.g., for instance, note that the communication chip 406 can be part of or otherwise integrated into the processor 404).

The communication chip 406 enables wireless communications for the transfer of data to and from the computing system 400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 406 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 400 may include a plurality of communication chips 406. For instance, a first communication chip 406 may be dedicated to shorter range wireless communications such as Wi-Fi and Bluetooth and a second communication chip 406 may be dedicated to longer range wireless communications such as GPS, EDGE, GPRS, CDMA, WiMAX, LTE, Ev-DO, and others.

The processor 404 of the computing system 400 includes an integrated circuit die packaged within the processor 404. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 406 also may include an integrated circuit die packaged within the communication chip 406. In accordance with some such example embodiments, the integrated circuit die of the communication chip includes one or more semiconductor devices as variously described herein. As will be appreciated in light of this disclosure, note that multi-standard wireless capability may be integrated directly into the processor 404 (e.g., where functionality of any chips 406 is integrated into processor 404, rather than having separate communication chips). Further note that processor 404 may be a chip set having such wireless capability. In short, any number of processor 404 and/or communication chips 406 can be used. Likewise, any one chip or chip set can have multiple functions integrated therein.

In various implementations, the computing system 400 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 400 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is a die that includes a plurality of semiconductor devices, an interconnect region above the plurality of semiconductor devices and having a plurality of interconnect layers, a material layer over the interconnect region, a dielectric bond layer on the material layer, and a substrate on the dielectric bond layer. The material layer has a thermal conductivity of at least 1.5 W/m·K.

Example 2 includes the die of Example 1, wherein the material layer comprises diamond.

Example 3 includes the die of Example 1, wherein the material layer comprises silicon and carbon.

Example 4 includes the die of Example 1, wherein the material layer comprises copper.

Example 5 includes the die of Example 1, wherein the material layer comprises boron and nitrogen.

Example 6 includes the die of Example 1, wherein the material layer comprises aluminum and nitrogen.

Example 7 includes the die of any one of Examples 1-6, wherein the material layer has a thickness between about 0.1 µm and about 5 µm.

Example 8 includes the die of any one of Examples 1-7, wherein the material layer has a substantially planar top surface with a roughness variation of less than 1 nm.

Example 9 includes the die of any one of Examples 1-8, wherein the material layer has a thermal conductivity of at least 100 W/m·K.

Example 10 includes the die of any one of Examples 1-9, wherein the substrate has a thickness between 50 µm and 800 µm.

Example 11 includes the die of any one of Examples 1-10, wherein the dielectric bond layer comprises silicon and oxygen or comprises titanium and oxygen.

Example 12 includes the die of any one of Examples 1-11, wherein the material layer is directly on a topmost layer of the plurality of interconnect layers.

Example 13 includes the die of any one of Examples 1-12, wherein the interconnect region is a first interconnect region and the die further comprises a second interconnect region below the plurality of semiconductor devices.

Example 14 is an electronic device that includes a chip package having one or more dies. At least one of the one or more dies includes a device layer comprising one or more semiconductor devices, one or more interconnect layers above the device layer, a material layer on a top surface of a topmost interconnect layer of the one or more interconnect layers, a dielectric bond layer on the material layer, and a substrate on the dielectric bond layer. The material layer has a thermal conductivity of at least 1.5 W/m·K.

Example 15 includes the electronic device of Example 14, wherein the material layer comprises diamond.

Example 16 includes the electronic device of Example 14, wherein the material layer comprises silicon and carbon.

Example 17 includes the electronic device of Example 14, wherein the material layer comprises copper.

Example 18 includes the electronic device of Example 14, wherein the material layer comprises boron and nitrogen.

Example 19 includes the electronic device of Example 14, wherein the material layer comprises aluminum and nitrogen.

Example 20 includes the electronic device of any one of Examples 14-19, wherein the material layer has a thickness between about 0.1 µm and about 5 µm.

Example 21 includes the electronic device of any one of Examples 14-20, wherein the material layer has a substantially planar top surface with a roughness variation of less than 1 nm.

Example 22 includes the electronic device of any one of Examples 14-21, wherein the material layer has a thermal conductivity of at least 100 W/m·K.

Example 23 includes the electronic device of any one of Examples 14-22, wherein the substrate has a thickness between 50 µm and 800 µm.

Example 24 includes the electronic device of any one of Examples 14-23, wherein the dielectric bond layer comprises silicon and oxygen or comprises titanium and oxygen.

Example 25 includes the electronic device of any one of Examples 14-24, wherein the at least one of the one or more dies further comprises one or more interconnect layers below the device layer.

Example 26 includes the electronic device of any one of Examples 14-25, further comprising a printed circuit board, wherein the chip package is attached to the printed circuit board.

Example 27 is an integrated circuit that includes a plurality of semiconductor devices, an interconnect region above the plurality of semiconductor devices and having a plurality of interconnect layers, a dielectric bond layer over the interconnect region, a material layer on the dielectric bond layer, and a substrate on the material layer. The material layer has a thermal conductivity of, for example, at least 1.5 W/m·K.

Example 28 includes the integrated circuit of Example 27, wherein the material layer comprises diamond.

Example 29 includes the integrated circuit of Example 27, wherein the material layer comprises silicon and carbon.

Example 30 includes the integrated circuit of Example 27, wherein the material layer comprises copper.

Example 31 includes the integrated circuit of Example 27, wherein the material layer comprises boron and nitrogen.

Example 32 includes the integrated circuit of Example 27, wherein the material layer comprises aluminum and nitrogen.

Example 33 includes the integrated circuit of any one of Examples 27-32, wherein the material layer has a thickness between about 0.1 µm and about 5 µm.

Example 34 includes the integrated circuit of any one of Examples 27-33, wherein the material layer has a substantially planar top surface with a roughness variation of less than 1 nm.

Example 35 includes the integrated circuit of any one of Examples 27-34, wherein the material layer has a thermal conductivity of at least 100 W/m·K.

Example 36 includes the integrated circuit of any one of Examples 27-35, wherein the substrate has a thickness between 50 µm and 800 µm.

Example 37 includes the integrated circuit of any one of Examples 27-36, wherein the dielectric bond layer comprises silicon and oxygen or comprises titanium and oxygen.

Example 38 includes the integrated circuit of any one of Examples 27-37, wherein the dielectric bond layer is directly on a topmost layer of the plurality of interconnect layers.

Example 39 includes the integrated circuit of any one of Examples 27-38, wherein the interconnect region is a first interconnect region and the integrated circuit further comprises a second interconnect region below the plurality of semiconductor devices.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. A die, comprising:
a plurality of semiconductor devices;
an interconnect region above the plurality of semiconductor devices, the interconnect region comprising a plurality of interconnect layers;
a material layer over the interconnect region, the material layer having a thermal conductivity of at least 1.5 W/m·K;
a dielectric bond layer on the material layer; and
a substrate on the dielectric bond layer.

2. The die of claim 1, wherein the material layer comprises diamond.

3. The die of claim 1, wherein the material layer comprises silicon and carbon.

4. The die of claim 1, wherein the material layer comprises copper.

5. The die of claim 1, wherein the material layer comprises boron and nitrogen.

6. The die of claim 1, wherein the material layer comprises aluminum and nitrogen.

7. The die of any one of claims 1-6, wherein the material layer has a thickness between about 0.1 µm and about 5 µm.

8. The die of any one of claims 1-7, wherein the material layer has a substantially planar top surface with a roughness variation of less than 1 nm.

9. The die of any one of claims 1-8, wherein the material layer has a thermal conductivity of at least 100 W/m·K.

10. The die of any one of claims 1-9, wherein the substrate has a thickness between 50 µm and 800 µm.

11. The die of any one of claims 1-10, wherein the dielectric bond layer comprises silicon and oxygen or comprises titanium and oxygen.

12. The die of any one of claims 1-11, wherein the material layer is directly on a topmost layer of the plurality of interconnect layers.

13. The die of any one of claims 1-12, wherein the interconnect region is a first interconnect region and the die further comprises a second interconnect region below the plurality of semiconductor devices.

14. An integrated circuit, comprising:
a plurality of semiconductor devices;
an interconnect region above the plurality of semiconductor devices, the interconnect region comprising a plurality of interconnect layers;
a dielectric bond layer over the interconnect region;
a material layer on the dielectric bond layer, the material layer having a thermal conductivity of at least 1.5 W/m·K; and
a substrate on the material layer.

15. The integrated circuit of claim 14, wherein the material layer has a thickness between about 0.1 µm and about 5 µm, wherein the material layer has a thermal conductivity of at least 100 W/m·K, wherein the dielectric bond layer comprises silicon and oxygen or comprises titanium and oxygen, wherein the dielectric bond layer is directly on a topmost layer of the plurality of interconnect layers.
